Europäisches Patentamt

(19) European Patent Office

Office européen des brevets

(11) Publication number: **0 234 761**
**A1**

(12) **EUROPEAN PATENT APPLICATION**

(21) Application number: **87300854.4**

(22) Date of filing: **30.01.87**

(51) Int. Cl.³: **H 03 D 1/10**

(30) Priority: **03.02.86 GB 8602579**

(43) Date of publication of application:
**02.09.87 Bulletin 87/36**

(84) Designated Contracting States:
**AT BE CH DE ES FR GB GR IT LI LU NL SE**

(71) Applicant: **BRITISH TELECOMMUNICATIONS public limited company**
**British Telecom Centre, 81 Newgate Street**
**London EC1A 7AJ(GB)**

(72) Inventor: **Greaves, Alan John**
**Antares Brick Kiln Needham Market**
**Ipswich Suffolk, IP6 8RZ(GB)**

(74) Representative: **Lloyd, Barry George William et al,**
**Intellectual Property Unit British Telecom Room 1304 151 Gower Street**
**London WC1E 6BA(GB)**

(54) **Detector-integrator.**

(57) An averaging circuit comprising an active half-wave rectifier (A₁,R₁,R₂,D₁,D₂) with an over-all capacitive feedback (C₂) arranged so as to effect low-pass filtering.

This circuit carries out detecting and integrating functions within the same stage; it exhibits a low output impedance and requires few components.

It can be constructed in an integrated-circuit form.

Fig.2a.

EP 0 234 761 A1

## DETECTOR - INTEGRATOR

This invention concerns an averaging circuit. In particular, it concerns an averaging circuit of the type which comprises an active rectifier followed by a low-pass filter.

Averaging circuits have many applications, for instance, they may be found in amplitude demodulators, or alternatively they may be found following each band-pass filter in a filter bank.

It is always an advantage, especially when a circuit is to be integrated, to minimise the component count. The area of a thick film hybrid circuit required for a filter bank comprising, say, sixteen band-pass filters and averaging circuits is highly sensitive to changes in the component count of each filter and averager. Reduction of the count by even one component per filter and averager creates a significant saving in circuit area.

According to the invention there is provided an averaging circuit comprising a high gain amplifier, a first diode connected between the amplifier output and an output of the circuit, and a negative feedback path provided between the output of the circuit and the amplifier input, wherein the negative feedback path includes a capacitor arranged so as to effect low-pass filtering.

Preferably the averaging circuit further includes a second diode connected between the input and output of the amplifier, the first and second diodes being arranged such that the cathode of one is connected to the anode of the other via the amplifier output.

A preferred embodiment of the invention will now be described by way of example with reference to the accompanying drawings, in which:

Figure 1a    shows a shown averaging circuit comprising an active rectifier and a first order low pass filter;

Figure 1b    shows a circuit equivalent to that of Figure 1a under certain conditions;

Figure 1c    shows a circuit equivalent to that of Figure 1a under certain other conditions;

Figure 2a    shows an averaging circuit embodying the present invention;

Figure 2b    shows a circuit equivalent to that of Figure 2a under certain conditions;

Figure 2c    shows a circuit equivalent to that of Figure 2a under certain other conditions.

The same reference numerals have been used throughout the drawings to refer to corresponding elements.

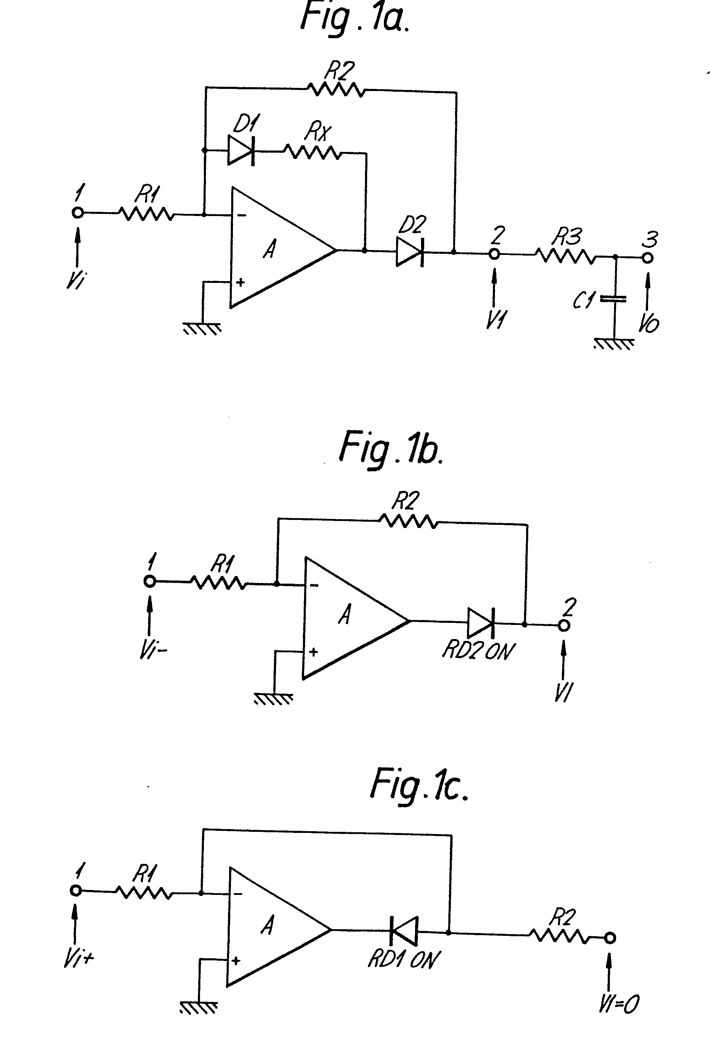

Referring now to Figure 1, a known averaging circuit will be described. In Figure 1a a half wave rectifier is shown, between points 1 and 2, to comprise an operational amplifier A connected with two diodes D1 and D2 and overall negative feedback R2. Resistor RX is optional and will be ignored in subsequent discussion.

When a negative input voltage Vi- is applied to the input, point 1, of the rectifier circuit: the output of the amplifier A is positive so that D1 is non-conducting (OFF) and D2 is conducting (ON). The rectifying circuit, under these conditions can be considered as equivalent to the configuration shown in Figure 1b (RD2ON is the 'ON resistance' of diode D2, but has no effect on the operation of the circuit if the gain of the amplifier A is high enough). The output voltage is given by:

$$V1 = \frac{-R2.Vi-}{R1} \qquad (1)$$

The output impedance of the rectifying circuit is low (equal to the output impedance of the amplifier A) under these conditions.

In exceptional circumstances the operation of the circuit can be altered, (while there is a negative input Vi-) in that, if a voltage that exceeds the voltage given by equation (1) is applied to point 2 then diode D2 is turned Off.

In the case when a positive input voltage Vi+ is applied to the input, point 1, the output of the amplifier A is negative and diode D1 is ON and diode D2 is OFF. The rectifying circuit can be considered as equivalent to that configuration shown in Figure 1c (RD1ON is the 'ON resistance' of Diode D1). Since there is no impedence in the feedback path the output voltage V1 is zero, and the output impedence is high (equal to R2) in this state. Again the operation of the circuit can be altered, in that, if a voltage less than

$$-\frac{R2.Vi+}{R1}$$

is applied to point 2 then:

the output of the amplifier A will be driven positive (the amplifier A can be considered to be acting as a summer with respect to inputs at points 1 and 2); and the diode D2 will turn ON so that the voltage at point 2 is pulled back up.

A first order low pass filter is shown in Figure 1a connected to the output of the rectifying circuit, between points 2 and 3. The transfer function of this filter is given by:

$$\frac{VO}{V1} = \frac{1}{(SC1R3+1)} \qquad (2)$$

In effect, this filter acts as a smoothing circuit removing any high frequency components and integrating the low frequency components to give an output envelope which is the average of the 'baseband' input signal.

Such a filter can, of course, be realised by an active equivalent circuit.

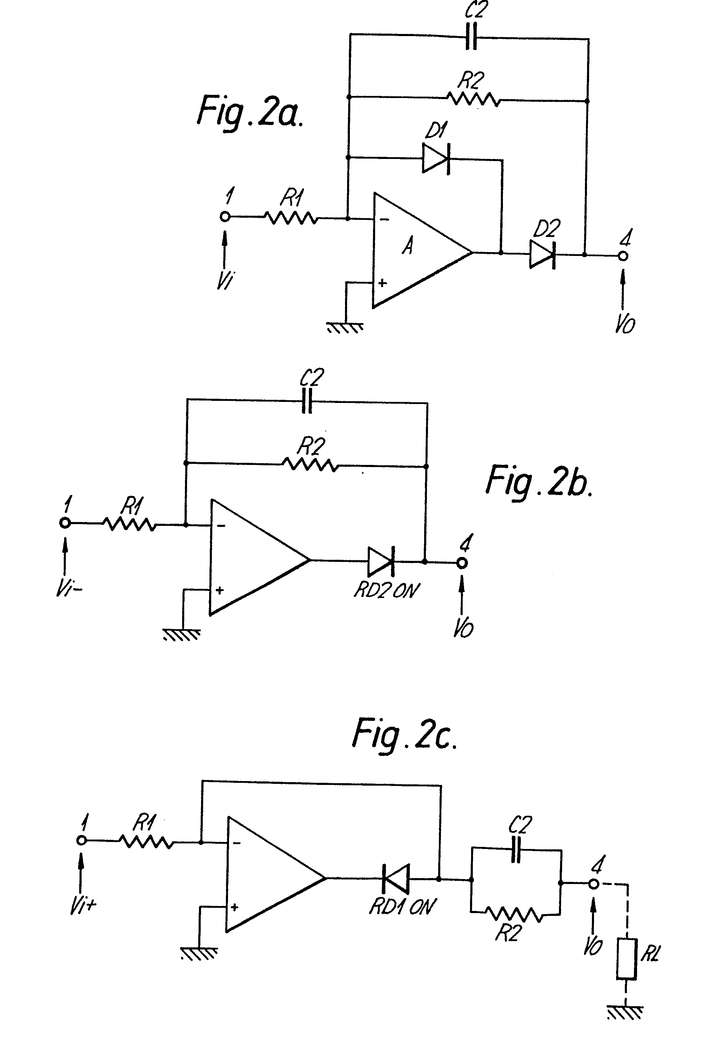

Referring now to Figure 2, a preferred embodiment of the invention will be described. The averaging circuit shown between points 1 and 4 in Figure 2a is the same as the rectifier circuit shown in Figure 1a between points 1 and 2, except that, an additional capacitor C2 has been included in parallel to the overall feedback resistor R2.

In the case when a negative input voltage Vi- is applied to point 1, the output of the amplifier A is positive, so diode D1 is OFF and diode D2 is ON (as before).

The averaging circuit, under these conditions, can be considered then as equivalent to that shown in Figure 2b. The output voltage is given by:

$$Vo = -\frac{R2}{R1} \cdot \frac{1}{(SC2R2+1)} \cdot Vi \qquad (3)$$

which is similar to equations (1) and (2) taken together and illustrates that the circuit operates as an averaging circuit.

When the input voltage applied to point 1 changes from negative Vi- to positive Vi+, the output of the amplifier A goes negative, diode D1 turns ON and D2 turns OFF; a circuit equivalent to that shown in Figure 2c. In this case, immediately after the input changes from negative to positive the voltage at point 4 is maintained at its previous (positive) value due to the presence of capacitor C2. Capacitor C2 begins to discharge through resistor R2 and the circuit load, represented by RL. The amount of current discharged through R2 has no affect on the operation of remainder of the circuit. However, whatever current is discharged through the load must be drawn from the current flowing through input resistor R1. If the voltage VC2 on the capacitor C2 is sufficiently high at any time that the current through the load (VC2/RL) exceeds the current through the input resistor (Vi+/R1) then the inverting input of the amplifier A will tend to go negative. This will cause the output of the amplifier A to go positive, diode D2 will turn back ON, and current from the amplifier will augment the current flowing through the load RL. While diode D2 is ON the output impedance of the entire averaging circuit is low (equal to that of the output of the amplifier A).

Provided the values of the components are chosen such that D2 turns back on as described above, then for a sinusoidal input signal Vi and a positive output voltage VO, diode D2 will be ON for more than half the input cycle. The averaging circuit embodying the invention illustrated in Figure 2a therefore has the advantage, when compared with the prior art circuit of Figure 1a, that it enjoys a lower output impedance over the input cycle as a whole - being low for more than half the cycle and equivalent to R2 in parallel with C2 for the remainder of the cycle. (The output impedance of the prior art averaging circuit never falls below R3 in parallel with C1, and at a maximum rises to R2 plus R3 in parallel with C1.)

Furthermore, and in any event, the embodiment of the invention requires fewer components that the prior art, since there is no equivalent to resistor R3 of Figure 1a in the circuit of Figure 2a.

Of course, it should be appreciated that the circuit described is for example only and the scope of the invention may include a variety of other arrangements. For example, the diodes may both be connected in the reverse directions to those shown; or a further stage of low-pass filtering may be cascaded following the circuit shown in Figure 2a. Also, it should be noted that in theory diode D1 is not necessary for the operation of the circuit as described. With conventional amplifying devices this diode must be included to prevent the output saturating to the power supply level since this causes the inverting input to cease behaving as a virtual earth.

## CLAIMS

1. An averaging circuit comprising a high gain amplifier, a first diode connected between the amplifier output and an output of the circuit, and a negative feedback path provided between the output of the circuit and the amplifier input, wherein the negative feedback path includes a capacitor arranged so as to effect low-pass filtering.

2. An averaging circuit as claimed in claim 1 which futher includes a second diode connected between the input and output of the amplifier, the first and second diodes being arranged such that the cathode of one is connected to the anode of the other via the amplifier output.

3. An averaging circuit as claimed in claim 1 or 2 in which the negative feedback path includes a resistor and a capacitor arranged in parallel.

4. An averaging circuit as claimed in any preceding claim in which the output of the averaging circuit is cascaded with a low-pass filter.

5. An averaging circuit as hereinbefore described with reference to Figure 2 of the accompanying drawings.

0234761

1/2

Fig.1a.

Fig.1b.

Fig.1c.

0234761

Fig.2a.

Fig.2b.

Fig.2c.

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | DE-A-2 237 111 (HARTMANN & BRAUN AG) <br> * Column 1, line 47 - column 4, line 17; figures 1,2 * | 1,2 | H 03 D 1/10 |
| Y | | 3 | |
| | --- | | |
| X | MEASUREMENT TECHNIQUES, vol. 26, no. 6, June 1983, pages 505-507, Plenum Publishing Corp., New York, US; I.M. VISHENCHUK et al.: "Measuring AC voltage converters of the V7-35 voltmeter" <br> * Page 506, line 42 - page 507, line 21; figure 2 * | 1,2 | |
| | --- | | |
| Y | IDEM | 3 | |
| | --- | | |
| A | PATENT ABSTRACTS OF JAPAN, vol. 7, no. 52 (E-162)[1197], 2nd March 1983; & JP-A-57 203 310 (NIPPON VICTOR K.K.) 13-12-1982 <br> * Whole abstract * | 4 | |
| | --- | | |
| A | FR-A- 789 094 (BOISSOU) <br> * Page 1, right-hand column, line 56 - page 2, left-hand column, line 21; figure 2 * | 4 | |
| | ----- | | |

**TECHNICAL FIELDS SEARCHED (Int. Cl 4)**

H 03 D
G 01 R

The present search report has been drawn up for all claims

| Place of search | Date of completion of the search | Examiner |
|---|---|---|
| THE HAGUE | 07-05-1987 | BALBINOT H. |